# EUROPEAN PATENT APPLICATION

(11) **EP 4 773 011 A1**
(43) Date of publication of application: **08.07.2026**
(21) Application number: 25223313.5
(22) Date of filing: 15.12.2025
(51) Int. Cl.: G06F 11/10, G11C 5/04, G11C 29/52

(54) **PLUGGABLE MEMORY APPARATUS, MEMORY APPLIANCE AND COMPUTING SYSTEM INCLUDING THE MEMORY APPLIANCE**

(30) Priority: 06.01.2025 KR 20250001638; 06.03.2025 US 202519072908
(71) Applicant: SK hynix Inc., Bubal-eub Icheon-si Gyeonggi-do 17336 (KR)
(72) Inventor: LEE, Seong Ju, San Jose, California, 95134 (US)
(74) Representative: Isarpatent

(57) **Abstract**

A pluggable memory apparatus includes a plurality of memory sockets, a slot, and a main controller. The slot connects with an external device. The main controller is communicably coupled to the plurality of memory sockets and the slot, and has error correction function. The main controller sets at least one data processing mode among a plurality of data processing modes based on error rates of a plurality of memory modules mounted in the plurality of memory sockets, and remaps input/output data according to the at least one data processing mode.

## Description

### BACKGROUND

### 1.TECHNICAL FIELD

Various embodiments generally relate to a semiconductor apparatus, and, more particularly, to a pluggable memory apparatus, a memory appliance and a computing system including the memory appliance.

### 2. RELATED ART

Many cloud service providers, such as Microsoft and Google, require large amounts of memory capacity to build their servers and use multiple memory apparatuses to provide the necessary storage space.

In order to efficiently manage multiple memory apparatuses, memory tiering technology, which separates memory apparatuses according to their purpose and stores data according to the frequency of access, is critical.

However, the performance of memory apparatuses inevitably degrades over time and with usage conditions. When the performance of a memory apparatus fails to meet predefined standards, it must be discarded. This leads to increased costs when degraded memory apparatuses are replaced.

Therefore, there is a need to develop technologies that can improve the performance of memory apparatuses or reuse degraded memory apparatuses instead of discarding them.

### SUMMARY

In an embodiment, a pluggable memory apparatus may include a plurality of memory sockets, a slot, and a main controller. The slot may be configured to connect with an external device. The main controller may be communicably coupled to the plurality of memory sockets and the slot, and may have an error correction function. The main controller may be configured to set at least one data processing mode, from among a plurality of data processing modes based on error rates of a plurality of memory modules mounted in the plurality of memory sockets and may be configured to remap input/output data according to the at least one data processing mode.

In an embodiment, a pluggable memory apparatus may include a plurality of memory modules, a slot and a main controller. The plurality of memory modules may be mounted in a plurality of memory sockets. The slot may be configured to connect with an external device. The main controller may be communicably coupled to the plurality of memory sockets and the slot, and may have error correction function. The main controller may include: at least one memory controller configured to perform training on the plurality of memory modules to detect error rates, configured to output memory management information including the error rates, and configured to generate error correction codes for input/output data; a host interface communicably coupled to at least one host through the slot; a data remapping circuit configured to remap the input/output data and the error correction codes according to at least one predetermined data processing mode; and a board management controller configured to set the at least one data processing mode, from among a plurality of data processing modes, for the plurality of memory modules based on the memory management information, and configured to transmit and receive the memory management information to and from the host interface.

In an embodiment, a memory appliance may include a plurality of pluggable memory apparatuses and a communication path manager. The plurality of pluggable memory apparatuses may be configured to perform training on a plurality of memory modules to detect error rates, may be configured to set at least one data processing mode among a plurality of data processing modes based on the error rates to perform data remapping operations including error correction, and may be configured to output memory management information including the error rates and the set data processing mode. The communication path manager may be configured to selectively couple at least one of the plurality of pluggable memory apparatuses with at least one external device in accordance with the memory management information.

In an embodiment, a computing system may include a plurality of hosts and a memory appliance. The plurality of hosts may be configured to output external device information including memory capacity and bandwidth for the plurality of hosts. The memory appliance may include a plurality of pluggable memory apparatuses, may be configured to perform data remapping operations including error correction by setting at least one data processing mode from among a plurality of data processing modes based on error rates of each of the plurality of pluggable memory apparatuses, and may be configured to allocate at least one of the plurality of pluggable memory apparatuses to each of the plurality of hosts based on the external device information.

### BRIEF DESCRIPTION OF THE DRAWINGS

FIGS. 1 and 2 are diagrams illustrating the configuration of a pluggable memory apparatus according to an embodiment of the present disclosure.
FIG. 3 is a diagram illustrating a configuration of a main controller according to an embodiment of the present disclosure.
FIG. 4 is a diagram illustrating differences in characteristics of data processing modes according to an embodiment of the present disclosure.
FIG. 5 is a diagram illustrating a configuration of a pluggable memory apparatus operating in a first data processing mode according to an embodiment of the present disclosure.
FIG. 6 is a diagram illustrating a data remapping method according to a first data processing mode.
FIG. 7 is a diagram illustrating a configuration of a pluggable memory apparatus operating in a second data processing mode according to an embodiment of the present disclosure.
FIG. 8 is a diagram illustrating a data remapping method according to a second data processing mode.
FIG. 9 is a diagram illustrating a configuration of a pluggable memory apparatus operating in a third data processing mode according to an embodiment of the present disclosure.
FIG. 10 is a diagram illustrating a data remapping method in a third data processing mode according to an embodiment of the present disclosure.
FIGS. 11 and 12 are diagrams illustrating a detailed operation of a data remapping method according to a third data processing mode.
FIG. 13 is a diagram illustrating a configuration of a main controller according to an embodiment of the present disclosure.
FIG. 14 is a diagram illustrating a data remapping method in connection with a fourth data processing mode according to an embodiment of the present disclosure.
FIGS. 15 to 18 are diagrams illustrating examples of applying data processing modes of a pluggable memory apparatus according to embodiments of the present disclosure.
FIG. 19 is a diagram illustrating a configuration of a memory appliance according to an embodiment of the present disclosure.
FIG. 20 is a diagram illustrating a configuration of a memory appliance according to an embodiment of the present disclosure.
FIG. 21 is a diagram illustrating a configuration of a computing system according to an embodiment of the present disclosure.
FIG. 22 is a diagram illustrating an example of a memory apparatus allocation method in a computing system according to an embodiment of the present disclosure.

### DETAILED DESCRIPTION

Various embodiments can improve the performance of memory apparatuses, improve the performance of used memory apparatuses by adjusting their operation-related modes so that they can be reused to reduce costs, and automatically allocate memory apparatuses to match the operating characteristics of hosts, enabling efficient system construction.

Hereinafter, embodiments of the present disclosure will be described in more detail with reference to the accompanying drawings.

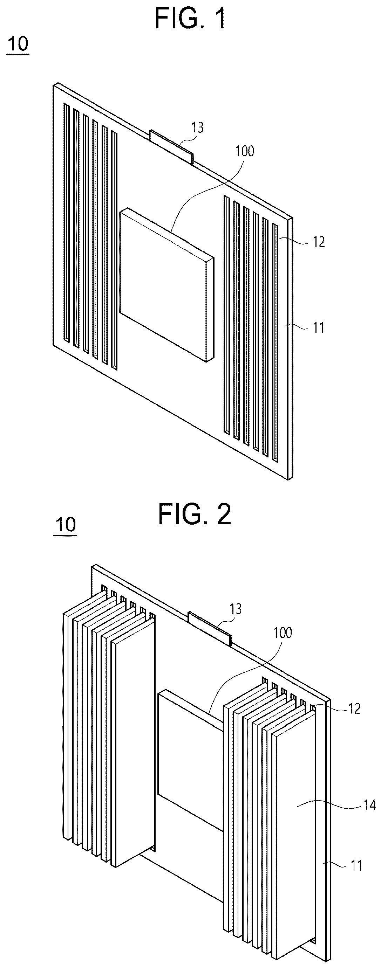

FIGS. 1 and 2 are diagrams illustrating the configuration of a pluggable memory apparatus according to an embodiment of the present disclosure.

Referring to FIG. 1, a pluggable memory apparatus 10 may include a substrate 11, a plurality of memory sockets 12, a slot 13, and a main controller 100.

The plurality of memory sockets 12, the slot 13, and the main controller 100 may be mounted on the substrate 11.

Referring to FIG. 2, the plurality of memory sockets 12 may be equipped with a plurality of memory modules 14. The plurality of memory modules 14 may each be a dual in-line memory module (DIMM).

The slot 13 allows the pluggable memory apparatus 10 to be indirectly or directly connected to a host.

The slot 13 and the main controller 100 may be configured to support a communication method, for example, Compute Express Link (CXL).

The main controller 100 may be communicably coupled to the plurality of memory sockets 12 and the slot 13, and may include an error correction function. The main controller 100 may perform training on the plurality of memory modules 14 to detect error rates and, based on the error rates, operate the plurality of memory modules 14 in at least one of a plurality of data processing modes having different error correction capabilities, memory capacities, and bandwidths. The training may be performed periodically or aperiodically, depending on internal settings or external requests. Each time training is performed, the error rate may change and the data processing mode may change accordingly.

The main controller 100 may set at least one data processing mode based on the error rates of the plurality of memory modules 14, from among a plurality of different data processing modes, and remap input/output data according to the at least one data processing mode.

The plurality of data processing modes may include a first data processing mode, a second data processing mode, and a third data processing mode. The first data processing mode may have a higher weighting of memory capacity and bandwidth relative to error correction capability. The second data processing mode may have a higher weighting of error correction capability relative to memory capacity and bandwidth. The third data processing mode may be set such that the weight of the error correction capability and the weight of the memory capacity and bandwidth have intermediate values between their values in the first data processing mode and the second data processing mode. While three data processing modes are described, in other embodiments more than three data processing modes may be implemented with different weighting of device characteristics and capabilities.

The main controller 100 may divide the plurality of memory modules 14 into a plurality of groups according to the first data processing mode, and may allocate different channels to each of the plurality of groups. The main controller 100 may divide the plurality of memory modules 14 into a plurality of groups according to a second data processing mode, allocate one channel to two different groups from among the plurality of groups, use one of the two different groups for storing normal data (hereinafter, data), and use the other of the two different groups for error correction. This same allocation method may be applied to the remaining groups in the second data processing mode. In the third data processing mode, the main controller 100 may divide the plurality of memory modules 14 into a plurality of groups, allocate one channel for a first group and a second group from among the plurality of groups, use at least one of the memory modules of the first group for error correction performed on the second group, and use the remainder of the memory modules for storing data of the first group. At least one of the memory modules of the second group is used in performing error correction on the first group, and the rest of the memory modules for storing second group data. This same allocation method may be applied to groups other than the first group and the second group.

The pluggable memory apparatus 10 can reuse memory modules that have been used and degraded in other systems by mounting them into the plurality of memory sockets 12. The pluggable memory apparatus 10 may apply an appropriate data processing mode to the plurality of memory modules 14 based on error rates. In particular, if an error rate exceeds a predetermined threshold, a data processing mode with a relatively enhanced error correction function may be applied to the memory module to prevent operation reliability from deteriorating. The word "predetermined" as used herein with respect to a parameter, such as a predetermined timing, time, or voltage level, means that a value for the parameter is determined prior to the parameter being used in a process or algorithm. For some embodiments, the value for the parameter is determined before the process or algorithm begins. In other embodiments, the value for the parameter is determined during the process or algorithm, but before the parameter is used in the process or algorithm.

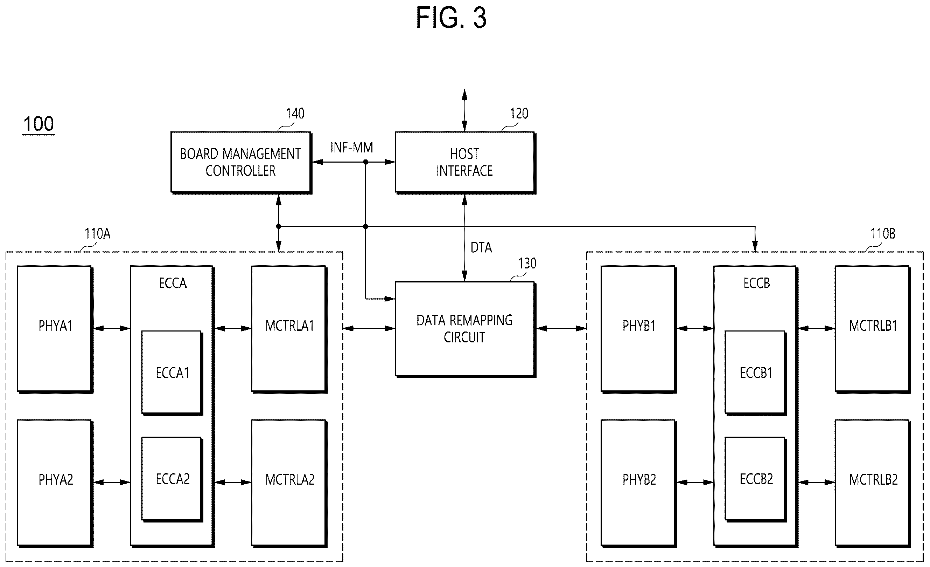

FIG. 3 is a diagram illustrating a configuration of a main controller according to an embodiment of the present disclosure.

Referring to FIG. 3, a main controller 100 may include a first memory controller 110A, a second memory controller 110B, a host interface 120, a data remapping circuit 130, and a board management controller 140.

The first memory controller 110A may perform training on a plurality of memory modules, coupled with itself, to detect error rates, output memory management information INF-MM including the error rates, and generate error correction codes for input/output data. The memory management information INF-MM may include at least one of error rate related information, data processing mode setting related information, memory capacity related information, and bandwidth related information.

The first memory controller 110A may categorize the plurality of memory modules, coupled to itself, into a plurality of groups, and may allocate channels to the plurality of groups according to a first data processing mode, a second data processing mode, and a third data processing mode. The first memory controller 110A may selectively utilize the plurality of memory modules for data storage or error correction code storage for each of the first data processing mode, the second data processing mode, and the third data processing mode.

The first memory controller 110A may include a plurality of memory interface blocks PHYA1, PHYA2, an error correction block ECCA, and a plurality of memory control blocks MCTRLA1, MCTRLA2.

The plurality of memory interface blocks PHYA1, PHYA2 may be coupled with a plurality of memory modules divided into a plurality of groups on a per-group basis. The plurality of memory interface blocks PHYA1, PHYA2 may be coupled with the plurality of memory sockets 12 as described with reference to FIGS. 1 and 2.

The error correction block ECCA may include a plurality of error correction circuits ECCA1, ECCA2. The plurality of error correction circuits ECCA1, ECCA2 may be in one-to-one or common connection with the plurality of memory interface blocks PHYA1, PHYA2 to generate error correction codes for data transmitted through the plurality of memory interface blocks PHYA1, PHYA2.

For example, the plurality of error correction circuits ECCA1, ECCA2 may have one-to-one connections with the plurality of memory interface blocks PHYA1, PHYA2 in the first data processing mode to generate error correction codes for data transmitted through the plurality of memory interface blocks PHYA1, PHYA2, respectively. In the second data processing mode, the plurality of error correction circuits ECCA1, ECCA2 may be in common connection with only one of the plurality of memory interface blocks PHYA1, PHYA2, and may generate error correction codes for data transmitted through only one of the plurality of memory interface blocks PHYA1, PHYA2.

The plurality of memory control blocks MCTRLA1, MCTRLA2 may be coupled to the plurality of error correction circuits ECCA1, ECCA2 and may perform training on the plurality of memory modules to detect error rates and generate memory management information INF-MM, including the error rates. The plurality of memory control blocks MCTRLA1, MCTRLA2 may control data input/output of the plurality of memory modules and the operations of the plurality of error correction circuits ECCA1, ECCA2. The plurality of memory control blocks MCTRLA1, MCTRLA2 may divide the plurality of memory modules into a plurality of groups, and allocate channels to the plurality of groups for the first data processing mode, the second data processing mode, and the third data processing mode. The plurality of memory control blocks MCTRLA1, MCTRLA2 may selectively utilize the plurality of memory modules for data storage or error correction code storage for each of the first data processing mode, the second data processing mode, and the third data processing mode.

The second memory controller 110B may include a plurality of memory interface blocks PHYB1, PHYB2, an error correction block ECCB, and a plurality of memory control blocks MCTRLB1, MCTRLB2. The second memory controller 110B may be configured to perform similar functions as those of the first memory controller 110A, so a detailed description of its configuration will be omitted.

FIG. 3 illustrates an example configuration of two memory controllers, but the number of memory controllers may vary depending on the number of memory modules.

The host interface 120 may be configured to support Compute Express Link and may communicate with at least one host through Compute Express Link.

The data remapping circuit 130 may remap input/output data and error correction codes to match at least one predetermined data processing mode.

The board management controller 140 may set at least one data processing mode among the first data processing mode, the second data processing mode, and the third data processing mode according to the memory management information INF-MM. The board management controller 140 may send and receive data DTA and the memory management information INF-MM to and from the host through the host interface 120. The board management controller 140 may set at least one data processing mode from among the first data processing mode, the second data processing mode, and the third data processing mode according to an error rate included in the memory management information INF-MM.

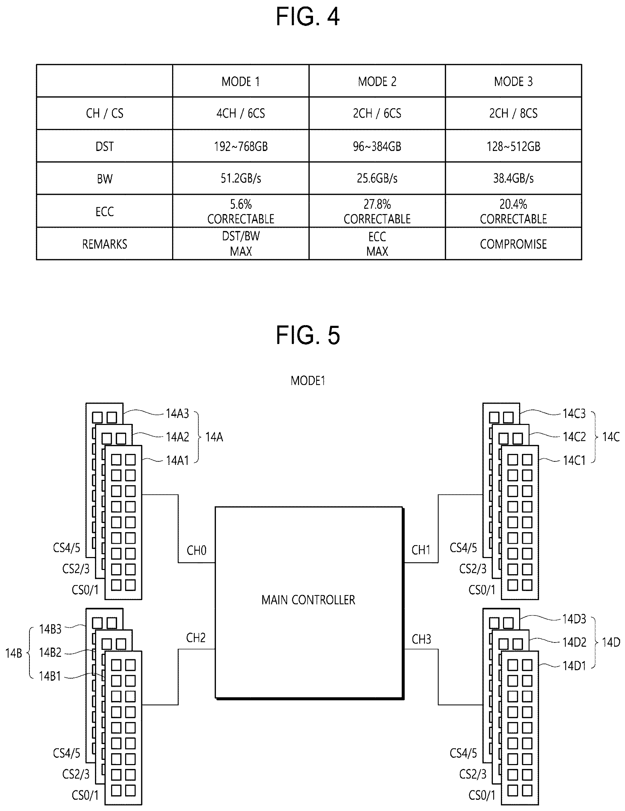

FIG. 4 is a diagram illustrating differences in characteristics of data processing modes according to an embodiment of the present disclosure. FIGS. 4 to 12 are illustrative of an example in which a pluggable memory apparatus 10 includes 12 memory modules, divides the 12 memory modules into four groups of three memory modules each, and each memory module has a capacity of 16-64 GB, but the number of memory modules, the number of groups, memory capacity, bandwidth, and error correction capability, etc. may vary depending on the design scheme in other embodiments and examples contemplated by this disclosure.

A first data processing mode MODE1, a second data processing mode MODE2, and a third data processing mode MODE3 of the present disclosure may be determined according to an error rate. For example, an error rate can be divided into three ranges: a first range with a low error rate, a second range with a medium or intermediate error rate, and a third range with a high error rate. The first range requires the least error correction capability, the second range requires moderate error correction capability, and the third range requires the highest error correction capability.

The first data processing mode MODE1 has a higher weighting of memory capacity and bandwidth relative to error correction capability, i.e., out of the total memory capacity, the memory capacity and bandwidth for data storage is higher than the memory capacity for error correction capability. In the first data processing mode MODE1, a portion of the total memory capacity of each of the plurality of memory modules may be used for error correction and the remainder of the memory capacity for data storage.

The second data processing mode MODE2 has a higher weighting of error correction capability relative to memory capacity and bandwidth, i.e., the memory capacity for error correction is set higher relative to the first data processing mode MODE1. In the second data processing mode MODE2, a plurality of memory modules is divided into a plurality of groups, the same channel is allocated for two different groups from among the plurality of groups, and one of the two groups using the same channel stores data while the other is used for error correction.

The third data processing mode MODE3 is set to have values in between the first data processing mode MODE1 and the second data processing mode MODE2 by changing the ratio of the weight of the error correction capability to the weight of the memory capacity and bandwidth, that is, the memory capacity and bandwidth for data storage and the memory capacity for the error correction capability have values that are intermediate between the first data processing mode MODE1 and the second data processing mode MODE2 as related to the total memory capacity. In the third data processing mode MODE3, the plurality of memory modules may be divided into a plurality of groups, the same channel may be allocated for a first group and a second group from among the plurality of groups, at least one of the memory modules of the first group may be used for error correction on the second group, and the rest of the memory modules of the first group may be used for data storage of first group data. At least one of the memory modules of the second group may be used for error correction on the first group, and the rest of the memory modules of the second group may be used for data storage of the second group.

Thus, the present disclosure can be set to the first data processing mode MODE1 when an error rate corresponds to a first range with the lowest error rate, the second data processing mode MODE2 when an error rate corresponds to a third range with the highest error rate, and the third data processing mode MODE3 when an error rate corresponds to a second range with a moderate error rate.

For example, referring to FIG. 4, in the first data processing mode MODE1, the memory modules may be controlled according to four channels 4CH and six memory selection signals 6CS: CS<5:0>. The memory capacity DST for storing data may be 192-768 GB, the bandwidth BW may be 51.2 GB/s, and the error correction circuit ECC may correct errors of 5.6% of the memory capacity, that is, a pluggable memory apparatus 10 has maximum performance in terms of memory capacity DST and bandwidth BW.

In the second data processing mode MODE2, the memory modules may be controlled according to two channels 2CH and six memory selection signals 6CS: CS<5:0>. The memory capacity DST for storing data may be 96-384 GB, the bandwidth BW may be 25.6 GB/s, and the error correction circuit ECC may correct errors of 27.8% of the memory capacity, that is, the pluggable memory apparatus 10 has maximum performance in terms of error correction.

In the third data processing mode MODE3, the memory modules may be controlled according to two channels 2CH and eight memory selection signals 8CS: CS<7:0>. The memory capacity DST for storing data may be 128-512 GB, the bandwidth BW may be 38.4 GB/s, and the error correction circuit ECC may correct errors of 20.4% of the memory capacity, that is, the pluggable memory apparatus 10 has a performance that is a compromise between memory capacity DST and bandwidth BW and error correction performance.

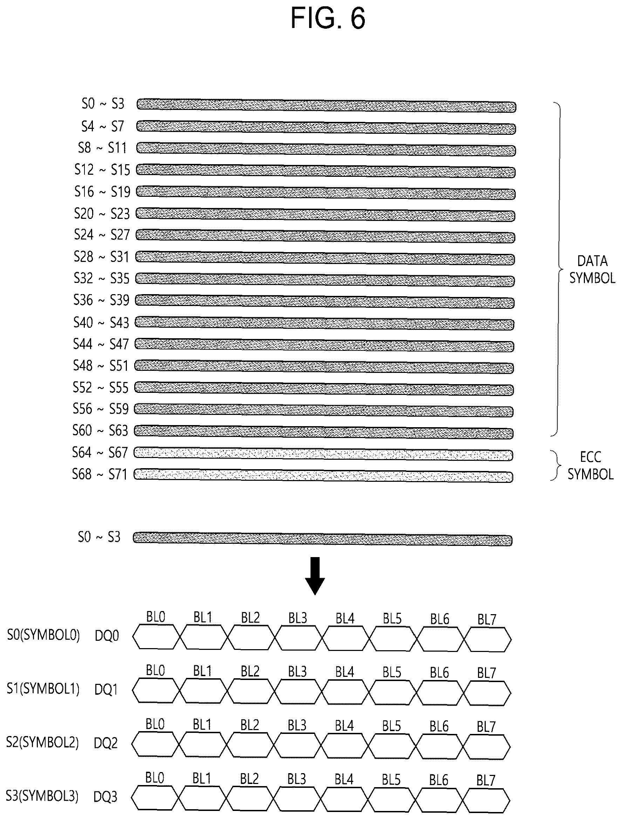

FIG. 5 is a diagram illustrating a configuration of a pluggable memory apparatus operating in a first data processing mode according to an embodiment of the present disclosure, and FIG. 6 is a diagram illustrating a data remapping method according to the first data processing mode.

Hereinafter, with reference to FIGS. 5 and 6, a configuration of a pluggable memory apparatus 10 of FIGS. 1 and 2 and a data remapping method according to the first data processing mode will be described.

Referring to FIG. 5, a plurality of memory modules 14 (see FIG. 2) may be divided into first to fourth groups 14A - 14D. Each of the first to fourth groups 14A - 14D may include a plurality of memory modules, for example, three memory modules. The first group 14A may include memory modules 14A1 - 14A3, the second group 14B may include memory modules 14B1 - 14B3, the third group 14C may include memory modules 14C1 - 14C3, and the fourth group 14D may include memory modules 14D1 - 14D3. Hereinafter, for ease of description, modules 14A1 - 14A3, 14B1 - 14B3, 14C1 - 14C3, and 14D1 - 14D3 will be referred to as first to twelfth memory modules. Each memory module may include a plurality of memory chips, such as 18 memory chips each. The number of memory chips included in each memory module is not limited and may vary depending on the type and capacity of the memory module.

The first group 14A may be coupled to a main controller through a first channel CH0, the second group 14B may be coupled to the main controller through a third channel CH2, the third group 14C may be coupled to the main controller through a second channel CH1, and the fourth group 14D may be coupled to the main controller through a fourth channel CH3. The main controller may be the main controller 100 described above with reference to FIG. 3.

The first to fourth groups 14A - 14D may each be selectively controlled by first to sixth memory selection signals CS<5:0>. For example, the first memory module 14A1 may have front memory chips and back memory chips selectively controlled by the first and second memory selection signals CS0/1, the second memory module 14A2 may have front memory chips and back memory chips selectively controlled by the third and fourth memory selection signals CS2/3, and the third memory module 14A3 may have front memory chips and back memory chips selectively controlled by the fifth and sixth memory selection signals CS4/5. The second to fourth groups 14B - 14D may also be selectively controlled by the first to sixth memory selection signals CS<5:0> in a manner similar to that of the first group 14A.

Referring to FIG. 6, a data remapping circuit 130 of the pluggable memory apparatus 10 may perform remapping of data output from the first to fourth groups 14A - 14D and data provided by the host to be written to the first to fourth groups 14A - 14D according to the first data processing mode MODE1. In the first data processing mode MODE1, 64 symbols S0 - S63 may be used as data symbols and 8 symbols S64 - S71 may be used as error correction code ECC symbols, making it possible to achieve remapping using a total of 72 symbols S0 - S71. For example, referring to the symbols S0 - S3, each symbol may be input and output through I/O pads DQO - DQ3 in an 8 burst length BL mode. The remaining symbols may be input and output through the I/O pads in a similar manner. Thus, the memory capacity and bandwidth of the pluggable memory apparatus 10 can be maximized.

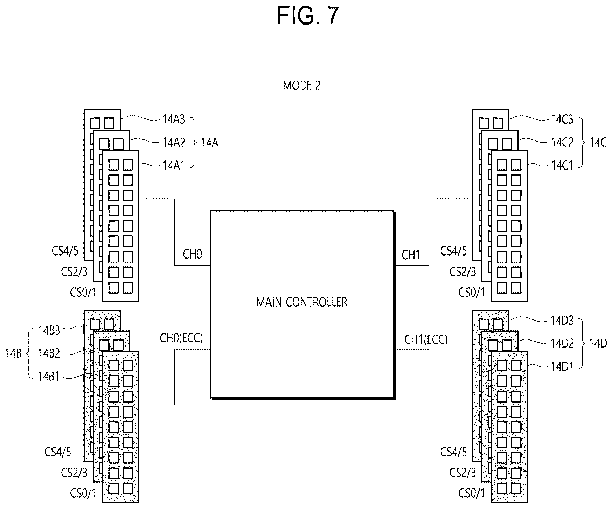

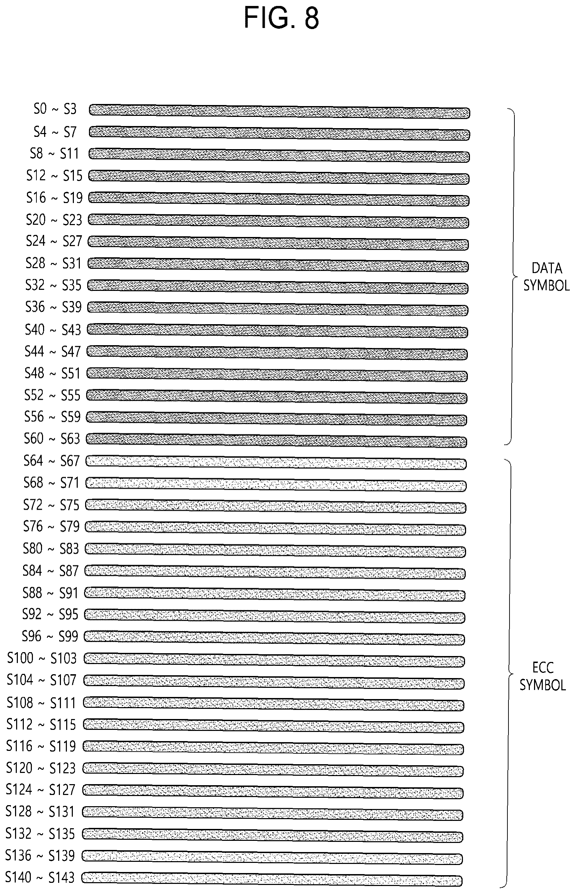

FIG. 7 is a diagram illustrating a configuration of a pluggable memory apparatus operating in a second data processing mode according to an embodiment of the present disclosure, and FIG. 8 is a diagram illustrating a data remapping method according to the second data processing mode.

Hereinafter, with reference to FIGS. 7 and 8, a configuration of a pluggable memory apparatus 10 described above with reference to FIGS. 1 and 2, and a data remapping method according to the second data processing mode, will be described.

Referring to FIG. 7, in the second data processing mode MODE2, memory modules of the first group 14A and the second group 14B may be coupled to a main controller through a first channel CH0, and memory modules of the third group 14C and the fourth group 14D may be coupled to the main controller through a second channel CH1. The main controller may be a main controller 100 described above with reference to FIG. 3. The first to fourth groups 14A - 14D may each be selectively controlled by the first to sixth memory selection signals CS<5:0>. In the second data processing mode MODE2, the manner in which the first to fourth groups 14A - 14D are selectively controlled by the first to sixth memory selection signals CS<5:0> is similar to that of the first data processing mode MODE1 described above with reference to FIG. 5, so a detailed description will be omitted here.

The first group 14A may be used for data storage, and the second group 14B may be used for error correction of the first group 14A. In some embodiments, the first group 14A is only used for data storage, and the second group 14B is only used for error correction of the first group 14A, The first group 14A and the second group 14B may be used for data storage and error correction in a one-to-one correspondence of memory modules receiving the same sequence of memory selection signals, i.e., the first memory module 14A1 receiving the memory selection signals CS0/1 may be used for data storage and the fourth memory module 14B1 receiving the memory selection signals CS0/1 may be used for error correction of the first memory module 14A1. The second memory module 14A2 receiving the memory selection signals CS2/3 may be used for data storage and the fifth memory module 14B2 receiving the memory selection signals CS2/3 may be used for error correction of the second memory module 14A2. The third memory module 14A3 receiving the memory selection signals CS4/5 may be used for data storage and the sixth memory module 14B3 receiving memory selection signals CS4/5 may be used for error correction of the third memory module 14A3.

The third group 14C may be used for data storage, and the fourth group 14D may be used for error correction of the third group 14C, and the method of use is similar to the method of use of the first group 14A and the second group 14B described above, so a detailed description will be omitted here.

Referring to FIG. 8, a data remapping circuit 130 of the pluggable memory apparatus 10 may perform remapping of data output from the first to fourth groups 14A - 14D and data provided by the host to be written to the first to fourth groups 14A - 14D according to the second data processing mode MODE2. For example, in the second data processing mode MODE2 using a first group 14A and a second group 14B, 64 symbols S0 - S63 may be used as data symbols, and 80 symbols S64 - S143 may be used as error correction code ECC symbols, making it possible to achieve remapping using a total of 144 symbols S0 - S143. Thus, the error correction capability of the pluggable memory apparatus 10 can be maximized.

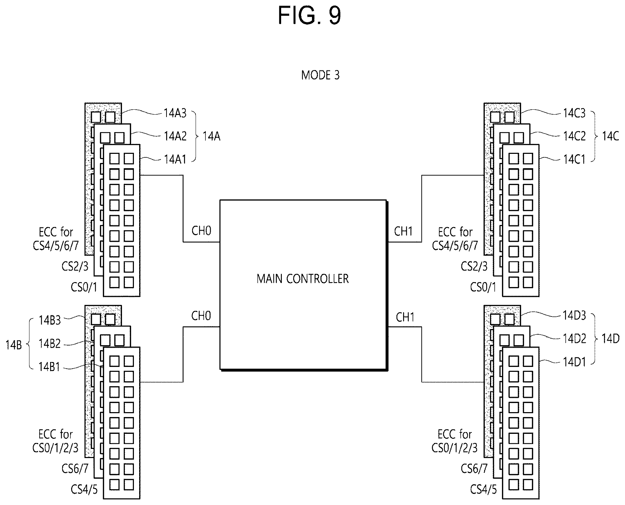

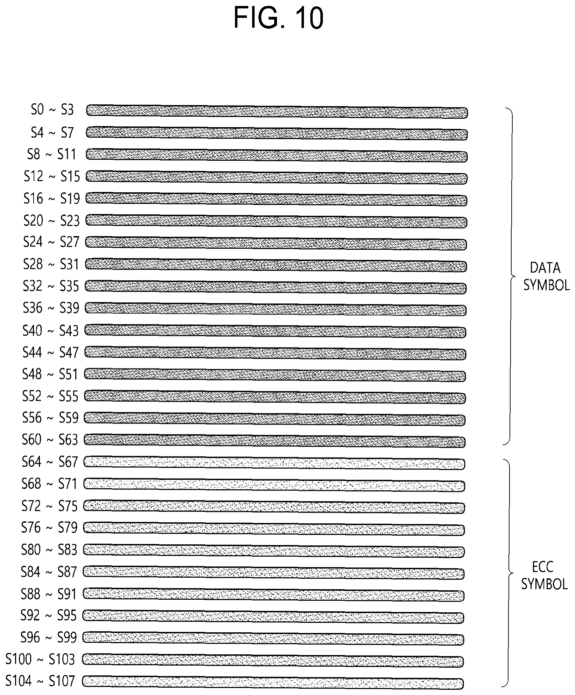

FIG. 9 is a diagram illustrating a configuration of the pluggable memory apparatus operating in a third data processing mode according to an embodiment of the present disclosure, and FIG. 10 is a diagram illustrating a data remapping method according to the third data processing mode.

Hereinafter, with reference to FIGS. 9 and 10, a configuration of a pluggable memory apparatus 10 described above with reference to FIGS. 1 and 2, and a data remapping method according to a third data processing mode, will be described.

Referring to FIG. 9, in the third data processing mode MODE3, the first group 14A and the second group 14B may be coupled to a main controller through a first channel CH0, and the third group 14C and the fourth group 14D may be coupled to the main controller through a second channel CH1. The main controller may be a main controller 100 described above with reference to FIG. 3. The first to fourth groups 14A - 14D may be selectively controlled by first to eighth memory selection signals CS<7:0>, respectively. The first memory module 14A1 may be controlled by the first and second memory selection signals CS0/1, the second memory module 14A2 may be controlled by the third and fourth memory selection signals CS2/3, and the third memory module 14A3 may be controlled by the fifth to eighth memory selection signals CS4/5/6/7. The fourth memory module 14B1 may be controlled by the fifth and sixth memory selection signals CS4/5, the fifth memory module 14B2 may be controlled by the seventh and eighth memory selection signals CS6/7, and the sixth memory module 14B3 may be controlled by the first to fourth memory selection signals CSO/1/2/3. The third group 14C may be selectively controlled by the first to eighth memory selection signals CS<7:0>, in a manner similar to the first group 14A, and the fourth group 14D may be selectively controlled by the first to eighth memory selection signals CS<7:0>, in a manner similar to the second group 14B.

One of the memory modules of the first group 14A may be used for error correction of the second group 14B and the rest may be used for data storage of the first group 14A, i.e., the first memory module 14A1 and the second memory module 14A2 of the first group 14A may be used for data storage and the third memory module 14A3 may be used for error correction of the fourth memory module 14B1 and the fifth memory module 14B2 of the second group 14B.

One of the memory modules of the second group 14B may be used for error correction of the first group 14A and the rest may be used for data storage of the second group 14B, i.e., the fourth memory module 14B1 and the fifth memory module 14B2 of the second group 14B may be used for data storage and the sixth memory module 14B3 may be used for error correction of the first memory module 14A1 and the second memory module 14A2 of the first group 14A.

One of the memory modules of the third group 14C may be used for error correction of the fourth group 14D and the rest may be used for data storage of the third group 14C, and one of the memory modules of the fourth group 14D may be used for error correction of the third group 14C and the rest may be used for data storage of the fourth group 14D. Because the usage of the memory modules of the third group 14C and the fourth group 14D is similar to the usage of the first group 14A and the second group 14B described above, a detailed description is omitted here.

Referring to FIG. 10, a data remapping circuit 130 of the pluggable memory apparatus 10 may perform remapping of data output from the first to fourth groups 14A - 14D and data provided by the host to be written to the first to fourth groups 14A - 14D according to the third data processing mode MODE3. In the third data processing mode MODE3, 64 symbols S0 - S63 may be used as data symbols and 44 symbols S64 - S107 may be used as error correction code ECC symbols, making it possible to achieve remapping using a total of 108 symbols S0 - S107. Thus, the error correction capability of the pluggable memory apparatus 10 can be traded off against memory capacity and bandwidth when compared to the second data processing mode.

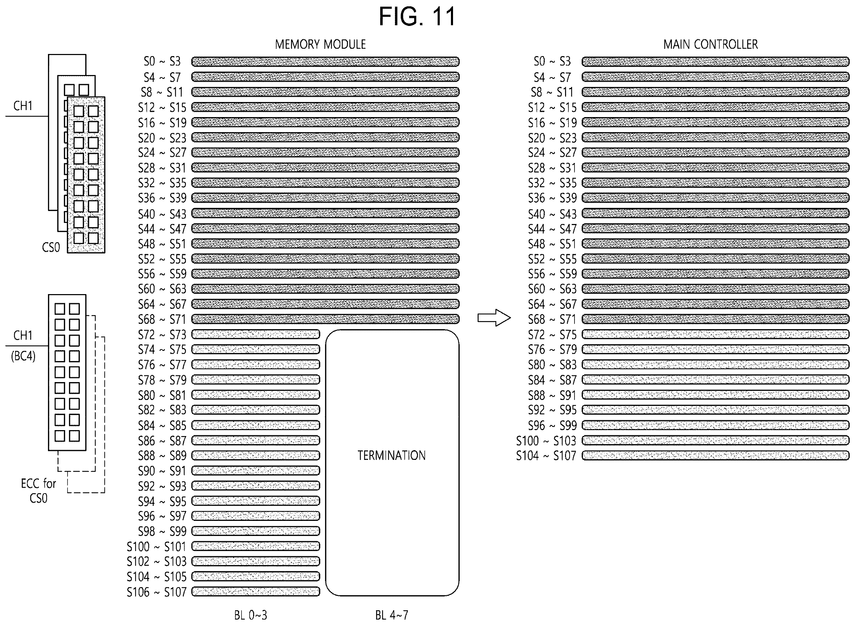

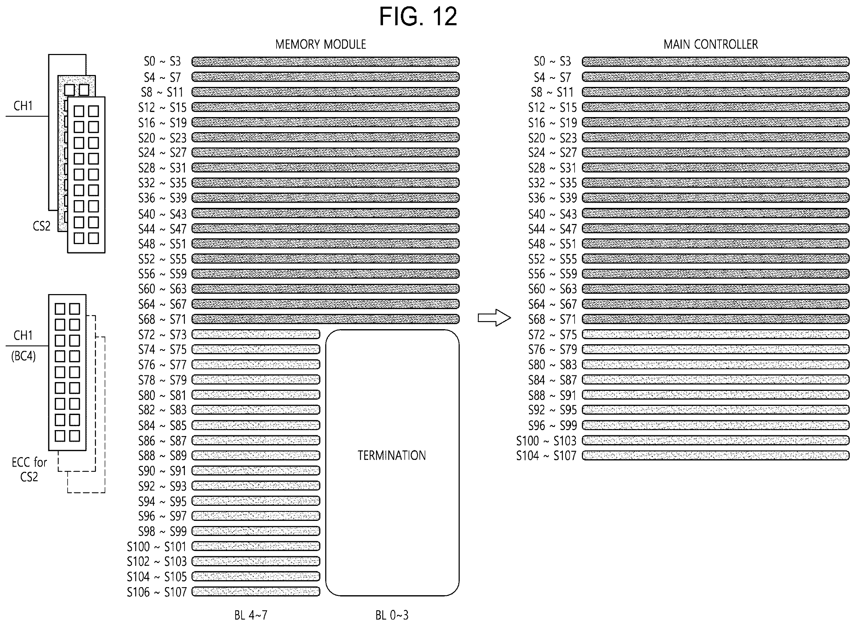

FIGS. 11 and 12 are diagrams illustrating a detailed operation of a data remapping method in a third data processing mode according to an embodiment of the present disclosure.

As described with reference to FIGS. 9 and 10, in the case of the third data processing mode MODE3 of the present disclosure, one memory module is allocated for error correction of two memory modules used for data storage. Therefore, the data write/read is performed according to burst split processing mode, i.e., the burst chop 4 (BC4) mode, instead of the burst length 8 mode described with reference to FIG. 6. In the third data processing mode MODE3, remapping proceeds by entering the BC4 mode, and then using the address signal (e.g., A2) to split the 8 bits of data per memory module into a first 4 bits and a second 4 bits for processing according to the BC4 mode.

First, referring to FIG. 11, when a value of the address signal A2 is '0', in a write operation, data corresponding to sequence numbers 0 - 3 of the data input/output pads DQ is stored in the memory cell region corresponding to burst length sequence numbers 0 - 3 in the memory module, and in a read operation, data output from the memory cell region in burst length sequence numbers 0 - 3 is output to the data input/output pads DQ of sequence numbers 0 -3.

When a value of the address signal A2 is '0', according to the memory selection signal CSO, the data output from the memory chips on the front side of one of the two memory modules for storing data, from among three memory modules in a first group coupled to the second channel CH1, is stored in the memory cell region corresponding to burst length 0 - 3 of the memory chips on the front side of the memory module, and used in error correction by a module in a second group coupled with the second channel CH1. And, according to the memory selection signal CS1 (not illustrated), the data output from the memory chips on the back side of one of the two memory modules for storing data, from among three memory modules in the first group coupled with the second channel CH1, is stored in the memory cell region corresponding to burst length 0 - 3 of the memory chips on the back side of the memory module, and used in error correction by a module in the second group coupled with the second channel CH1. Meanwhile, the data output corresponding to burst length 4 - 7 is blocked, i.e., terminated. As described above, the main controller can remap the data in the memory module using a total of 108 symbols S0 - S107.

Next, referring to FIG. 12, when a value of the address signal A2 is '1', according to the memory selection signal CS2, the data outputted from the memory chips on the front side of the other of the two memory modules for storing data, from among the three memory modules in the first group coupled with the second channel CH1, is stored in the memory cell region corresponding to burst length 4 - 7 of the memory chips on the front side of the memory module, and used in error correction by a module in the second group coupled with the second channel CH1. Then, according to the memory selection signal CS3 (not illustrated), the data output from the memory chips on the back side of the other of the two memory modules for storing data, from among three memory modules of the first group coupled with the second channel CH1, is stored in the memory cell region corresponding to burst length 4 - 7 of the memory chips on the back side of the memory module, and used for error correction by a module in the second group coupled with the second channel CH1. Meanwhile, the data output corresponding to burst length 0 - 3 is blocked, i.e., terminated. As described above, the main controller can remap the data in the memory module using a total of 108 symbols S0 - S107.

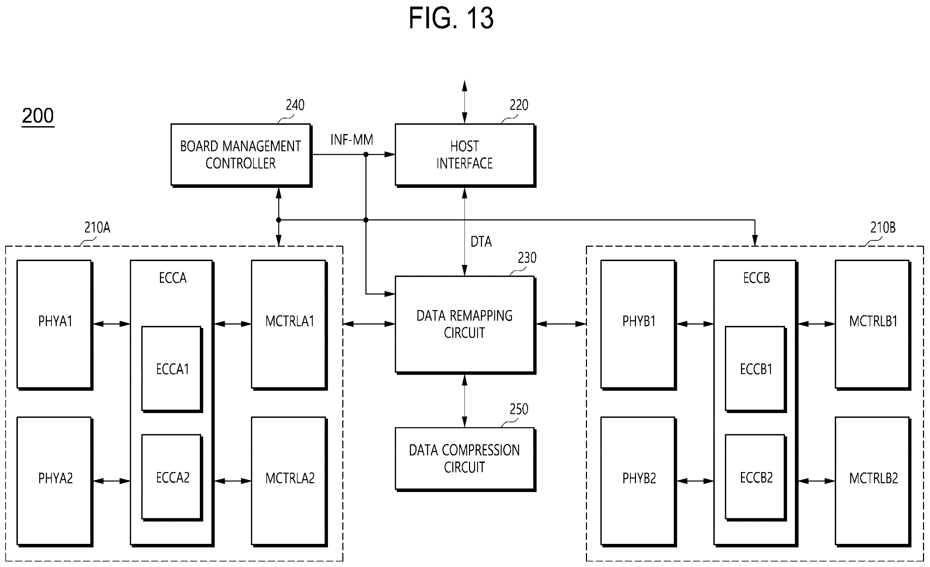

FIG. 13 is a diagram illustrating a configuration of a main controller according to an embodiment of the present disclosure.

A main controller 200 may support a first data processing mode, a second data processing mode, and a third data processing mode, and may further support a fourth data processing mode with increased memory capacity for error correction function by compressing data according to each of the first data processing mode, the second data processing mode, and the third data processing mode.

Referring to FIG. 13, the main controller 200 may include a first memory controller 210A, a second memory controller 210B, a host interface 220, a data remapping circuit 230, a board management controller 240, and a data compression circuit 250.

The first memory controller 210A may perform training on a plurality of memory modules coupled with itself to detect error rates, output memory management information INF-MM including the error rates, and generate error correction codes for input/output data. The memory management information INF-MM may include at least one of an error rate, a data processing mode, a memory capacity, and a bandwidth.

The first memory controller 210A may categorize the plurality of memory modules coupled with it into a plurality of groups, and may allocate channels to the plurality of groups for the first data processing mode, the second data processing mode, the third data processing mode, and the fourth data processing mode. The first memory controller 210A may selectively utilize a plurality of memory modules for data storage or error correction code storage for the first data processing mode, the second data processing mode, the third data processing mode, and the fourth data processing mode.

The second memory controller 210B may be configured to perform similar functions as performed by the first memory controller 210A, so a detailed configuration description will be omitted here.

FIG. 13 illustrates an example configuration of two memory controllers, but the number of memory controllers may vary depending on the number of memory modules.

The host interface 220 may be configured to support Computer Express Link and may communicate with at least one host through Computer Express Link.

The first memory controller 210A, the second memory controller 210B, and the host interface 220 may be configured in a similar way as the first memory controller 110A, the second memory controller 110B, and the host interface 120 described above with reference to FIG. 3 so a detailed description will be omitted here.

The data remapping circuit 230 may remap input/output data and error correction codes to match at least one predetermined data processing mode.

The data compression circuit 250 may compress data provided by the data remapping circuit 230 to generate compressed data, and may provide the compressed data to the data remapping circuit 230.

The board management controller 240 may set at least one data processing mode, from among the first data processing mode, the second data processing mode, the third data processing mode, and the fourth data processing mode, according to the memory management information INF-MM. The board management controller 240 may send and receive data DTA and memory management information INF-MM to and from the host through the host interface 220. The board management controller 240 may set at least one data processing mode from among the first data processing mode, the second data processing mode, and the third data processing mode based on an error rate included in the memory management information INF-MM. The board management controller 240 may set the fourth data processing mode according to an internal setting or an external request through the memory management information INF-MM.

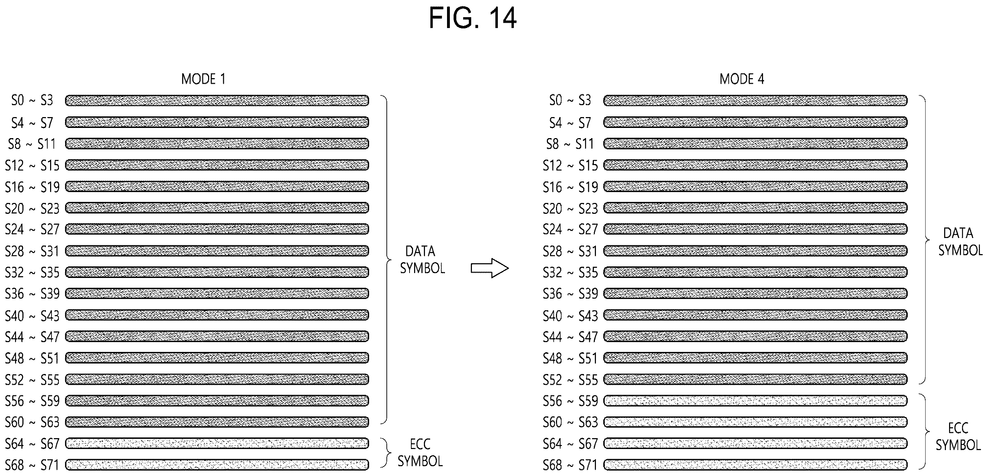

FIG. 14 is a diagram illustrating a data remapping method in connection with a fourth data processing mode according to an embodiment of the present disclosure.

A fourth data processing mode is a mode for compressing data according to each of the first data processing mode, the second data processing mode, and the third data processing mode. It may be implemented concurrently as an additional option in the operational methods of the first, second, and third data processing modes.

Referring to FIG. 14, when the first data processing mode is set and the fourth data processing mode is requested, data remapping may be performed using compressed data generated by compressing the data according to the first data processing mode.

When the fourth data processing mode is added to the first data processing mode, the number of data symbols may be reduced to 56 (e.g., S0 - S55) and the number of error correction code symbols may be increased to 16 (e.g., S56 - S71), compared to the first data processing mode, while keeping the total number of symbols at 72 (e.g., S0 - S71), which is the same as in the first data processing mode. Thus, the error correction code symbols can be increased while error correction ability increases.

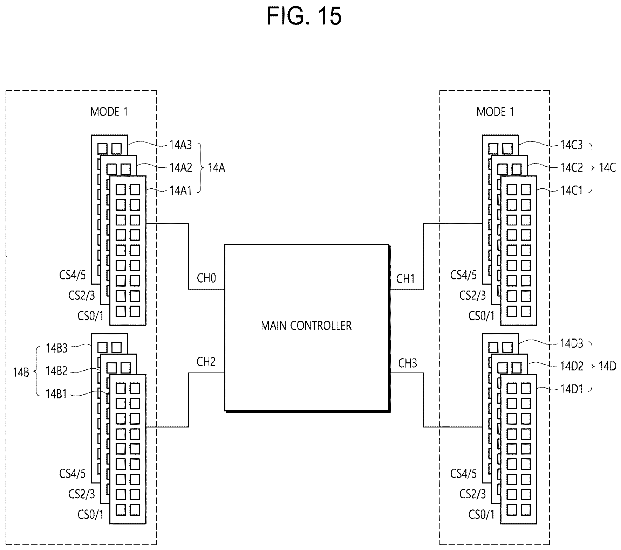

FIGS. 15 to 18 are diagrams illustrating examples of applying data processing modes of a pluggable memory apparatus according to embodiments of the present disclosure.

Referring to FIG. 15, a main controller performs training on memory modules included in a first group to a fourth group (see FIG. 5), and as a result, it is important to increase the memory capacity and bandwidth when the error rates of the first group to the fourth group are in the first range. Therefore, the main controller may set a first data processing mode MODE1 for the first group to the fourth group. The main controller may be one of a main controller 100 described above with reference to FIG. 3 or a main controller 200 described above with reference to FIG. 13.

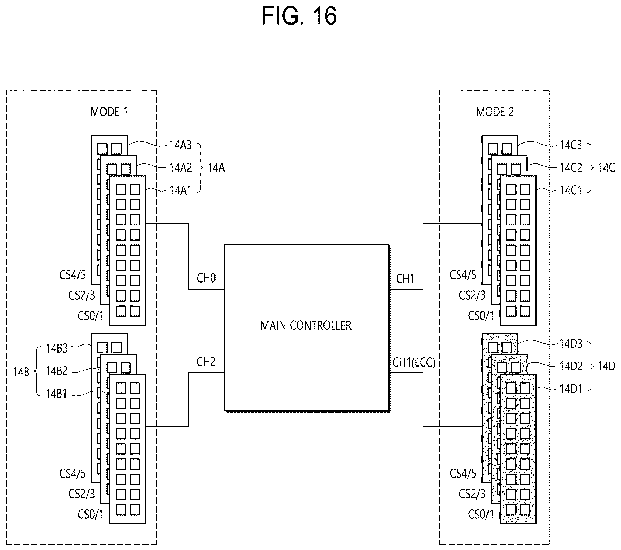

Referring to FIG. 16, the main controller may perform training on the memory modules included in the first group to the fourth group, and as a result, if the error rates of the first group and the second group are in the first range and the error rates of the third group and the fourth group are in the third range, it is advantageous to increase the memory capacity and bandwidth for the first group and the second group and to increase operation reliability by enhancing the error correction capability for the third group and the fourth group. Therefore, the main controller may set the first data processing mode MODE1 for the first group and the second group and allocate different channels CH0, CH2 for the first and second groups, and set the second data processing mode MODE2 for the third group and the fourth group and allocate the same channel CH1 for the third group and the fourth group. The main controller may be one of the main controller 100 described with reference to FIG. 3 or the main controller 200 described with reference to FIG. 13.

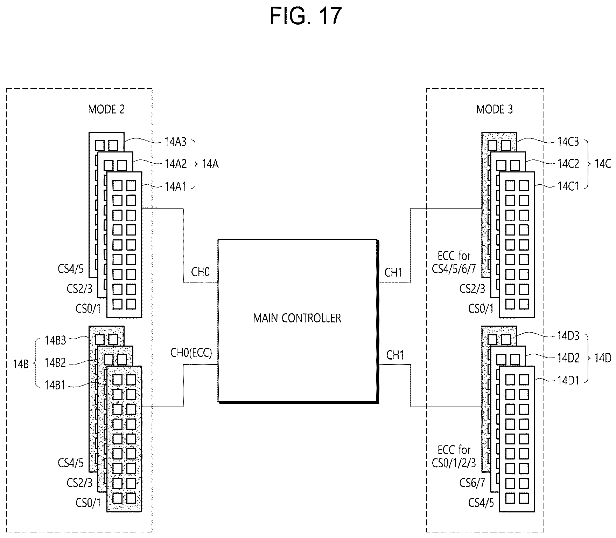

Referring to FIG. 17, the main controller may perform training on the memory modules included in the first group to the fourth group, and as a result, if the error rates of the first group and the second group are included in the third range, but the error rates of the third group and the fourth group are included in the second range, then it is advantageous to increase operational reliability by enhancing the error correction capability for the first group and the second group, and it is desirable to trade off the error correction capability with memory capacity and bandwidth for the third group and the fourth group. Therefore, the main controller may set the second data processing mode MODE2 for the first group and the second group and allocate the same channel CH0, and set the third data processing mode MODE3 for the third group and the fourth group and allocate the same channel CH1. The main controller may be one of the main controller 100 described with reference to FIG. 3 or the main controller 200 described with reference to FIG. 13.

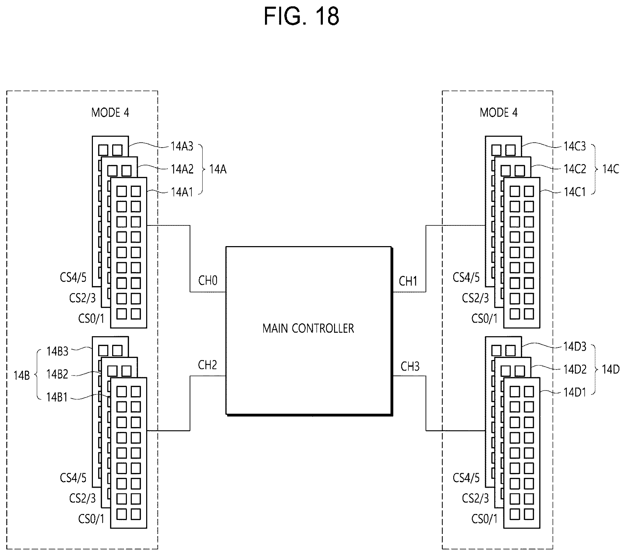

Referring to FIG. 18, the main controller may set the fourth data processing mode MODE4 for the first group to the fourth group based on an internal setting or an external request. In this case, the fourth data processing mode MODE4 operates in parallel with one of the first data processing mode MODE1, the second data processing mode MODE2, and the third data processing mode MODE3. FIG. 18 illustrates an example where the fourth data processing mode MODE4 is operating in parallel with the first data processing mode MODE1. The main controller may be a main controller 200 described with reference to FIG. 13.

The main controller may perform training on the memory modules included in the first to fourth groups, and if detected error rates of the first to fourth groups fall within the first range, and it can apply the data remapping method according to the first data processing mode MODE1 to the first to fourth groups and allocate different channels CH0 - CH3. In this state, when a request for the fourth data processing mode MODE4 occurs, the main controller may set the fourth data processing mode MODE4 in which the data processed according to the first data processing mode MODE1 is compressed to improve the error correction capability.

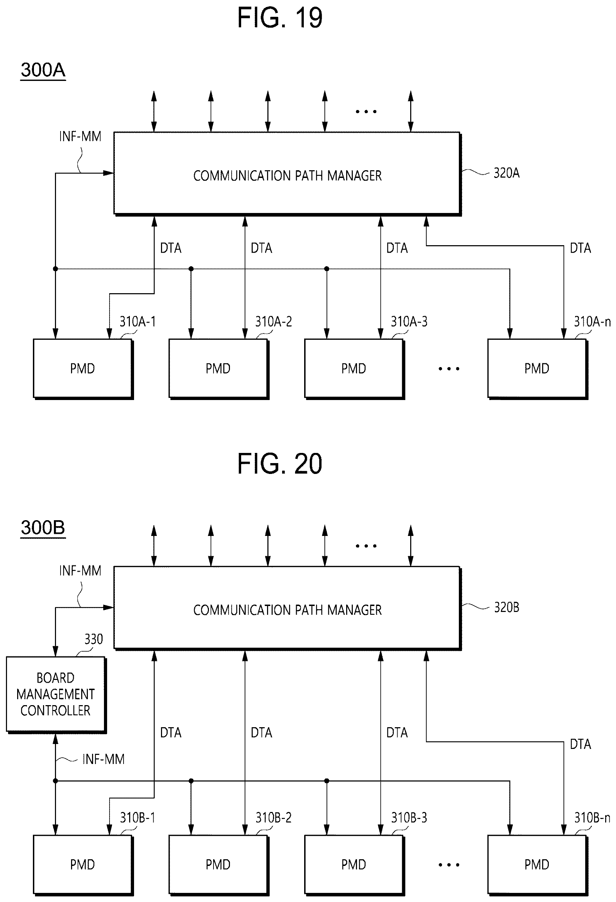

FIG. 19 is a diagram illustrating a configuration of a memory appliance according to an embodiment of the present disclosure.

Referring to FIG. 19, a memory appliance 300A may include a plurality of pluggable memory apparatuses PMD 310A-1 - 310A-n and a communication path manager 320A. The memory appliance 300A may perform internal and external communications over Computer Express Link.

The plurality of pluggable memory apparatuses 310A-1 - 310A-n each may be configured similarly to a pluggable memory apparatus 10 described above with reference to FIGS. 1 to 18.

The plurality of pluggable memory apparatuses 310A-1 - 310A-n may each perform training on the memory modules coupled with them to detect error rates. Based on the detected error rates, one or more of the first data processing mode, the second data processing mode, the third data processing mode, and the fourth data processing mode may be set to perform a data remapping operation.

The plurality of pluggable memory apparatuses 310A-1 - 310A-n may receive and output memory management information INF-MM and data DTA. The memory management information INF-MM may include at least one of error rate related information, data processing mode setting related information, memory capacity related information, and bandwidth related information. The data processing mode setting related information may further include a fourth data processing mode request information. The memory management information INF-MM may further include external device information. The external device information is information provided by an external device, i.e., a host, to the memory appliance 300A, and may include memory capacity, bandwidth, and latency information required by the host.

The communication path manager 320A may selectively couple the plurality of pluggable memory apparatuses 310A-1 - 310A-n with at least one host based on the memory management information INF-MM. The communication path manager 320A may include a Fabric Manager or a Compute Express Link switch.

The communication path manager 320A may store the memory capacity and bandwidth of the plurality of pluggable memory apparatuses 310A-1 - 310A-n and the memory capacity and bandwidth required by each host according to memory management information INF-MM. The communication path manager 320A may selectively connect to at least one pluggable memory apparatus set with a data processing mode corresponding to at least one host according to the memory management information INF-MM.

FIG. 20 is a diagram illustrating a configuration of a memory appliance according to an embodiment of the present disclosure.

Referring to FIG. 20, a memory appliance 300B may include a plurality of pluggable memory apparatuses PMD 310B-1 - 310B-n, a communication path manager 320B, and a board management controller 330. The memory appliance 300B may perform internal and external communications over Computer Express Link.

A pluggable memory apparatus 10 described above with reference to FIGS. 1 to 18 is an example of a configuration that includes a board management controller. The plurality of pluggable memory apparatuses 310B-1 - 310B-n according to FIG. 20 are illustrated as sharing a single board management controller 330, rather than each having an embedded board management controller.

The plurality of pluggable memory apparatuses 310B-1 - 310B-n may also be configured as a pluggable memory apparatus 10 described above with reference to FIGS. 1 to 18, except without a board management controller.

The plurality of pluggable memory apparatuses 310B-1 - 310B-n may each perform training on the memory modules coupled with them to detect error rates and output memory management information INF-MM, including the detected error rates. The plurality of pluggable memory apparatuses 310B-1 - 310B-n may each remap data DTA according to a set data processing mode.

The communication path manager 320B may selectively couple the plurality of pluggable memory apparatuses 310B-1 - 310B-n with at least one host based on the memory management information INF-MM. The communication path manager 320B may include a Fabric Manager or a Compute Express Link switch. The memory management information INF-MM may include at least one of error rate related information, data processing mode setting related information, memory capacity related information, and bandwidth related information. The memory management information INF-MM may further include external device information.

Based on the memory management information INF-MM, the communication path manager 320B may know the memory capacity and bandwidth of the plurality of pluggable memory apparatuses 310B-1 - 310B-n and the memory capacity and bandwidth required by each host. The communication path manager 320B may selectively connect to at least one pluggable memory apparatus corresponding to at least one host according to the memory management information INF-MM.

The board management controller 330 may set the data processing mode of each of the plurality of pluggable memory apparatuses 310B-1 - 310B-n to at least one, or one or more, of the first data processing mode, the second data processing mode, the third data processing mode, and the fourth data processing mode according to the memory management information INF-MM provided by each of the plurality of pluggable memory apparatuses 310B-1 - 310B-n. The board management controller 330 may send and receive memory management information INF-MM to and from the host through the communication path manager 320B.

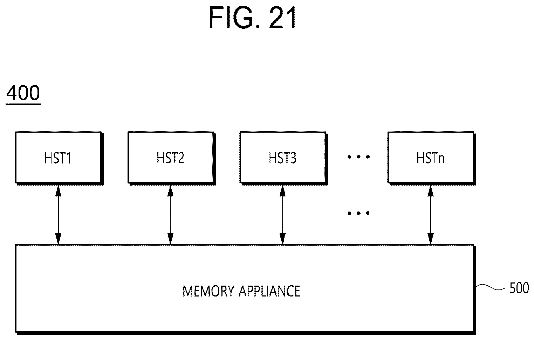

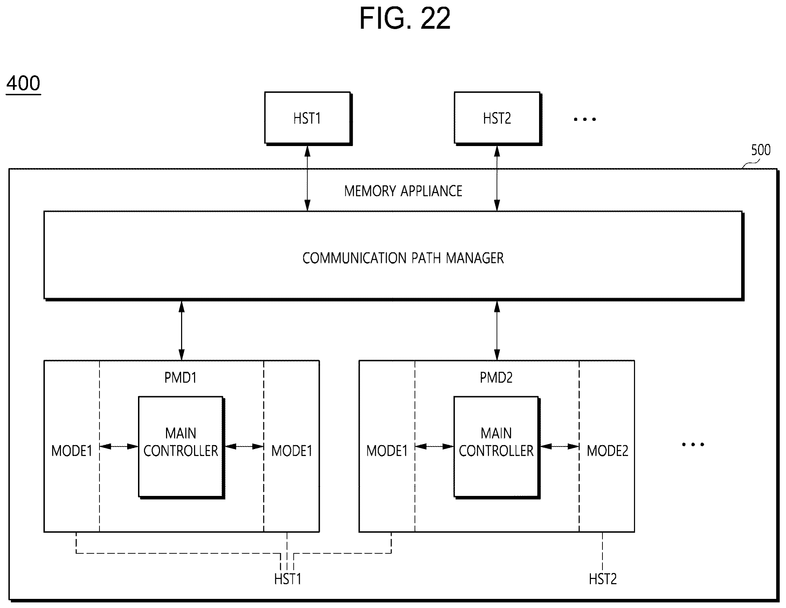

FIG. 21 is a diagram illustrating a configuration of a computing system according to an embodiment of the present disclosure, and FIG. 22 is a diagram illustrating an example of a memory apparatus allocation method in a computing system according to an embodiment of the present disclosure.

Hereinafter, with reference to FIGS. 21 and 22, a configuration of a computing system 400 and a memory apparatus allocation method according to an embodiment of the present disclosure will be described.

Referring to FIG. 21, the computing system 400 may include a memory appliance 500 and a plurality of hosts HTS1 - HTSn.

The memory appliance 500 may be configured similarly to a memory appliance 300A described above with reference to FIG. 19 or a memory appliance 300B described above with reference to FIG. 20, and the configurations of which will not be repeated here.

The plurality of hosts HTS1 - HTSn may provide memory management information to the memory appliance 500, and in response the memory appliance 500 stores memory capacity, bandwidth, and latency information appropriate for the plurality of hosts.

As described above, the memory appliance 500 may set at least one, or one or more, data processing mode based on the error rate of each of the plurality of pluggable memory apparatuses, and may store memory capacity and bandwidth according to the set data processing mode and memory capacity, bandwidth, and latency information required by the host. Thus, the memory appliance 500 may allocate at least one pluggable memory apparatus to each of the plurality of hosts HTS1 - HTSn to enable data communication.

FIG. 22 illustrates an example of allocating and connecting a first pluggable memory apparatus PWD1 and a second pluggable memory apparatus PWD2 to a first host HST1 and a second host HST2, from among the plurality of hosts HTS1 - HTSn.

Referring to FIG. 22, it is assumed that the first pluggable memory apparatus PWD1 has first data processing mode MODE1 set for all memory modules, and the second pluggable memory apparatus PWD2 has first data processing mode MODE1 set for memory modules corresponding to a first group and a second group, and second data processing mode MODE2 set for memory modules corresponding to a third group and a fourth group. It is further assumed that the first host HST1 is a host for which a high capacity and high bandwidth memory type is appropriate, and that the second host HST2 is a host for which a relatively low capacity and low bandwidth memory type is appropriate.

Based on the stored memory management information, the communication path manager of the memory appliance 500 may allocate and connect all memory modules of the first pluggable memory apparatus PWD1 and memory modules corresponding to the first group and the second group of the second pluggable memory apparatus PWD2 to the first host HST1, and allocate and connect memory modules corresponding to the third group and the fourth group of the second pluggable memory apparatus PWD2 to the second host HST2. In other words, the memory appliance 500 may allocate one pluggable memory apparatus to a plurality of hosts, by assigning memory modules of different groups to different hosts, based on memory management information including external device information, and may also allocate a plurality of pluggable memory apparatuses to a single host.

Although not directly shown in FIG. 22, it is also possible to allocate and connect the first pluggable memory apparatus PWD1 to the first host HST1 and the second pluggable memory apparatus PWD2 to the second host HST2 in one-to-one relationships.

In another example, if any of the plurality of hosts HTS1 - HTSn performs a latency-insensitive role, the memory appliance 500 may be requested to implement the fourth data processing mode using memory management information.

In response to the setting of the fourth data processing mode, the memory appliance 500 may set some or all memory modules of at least one of the plurality of pluggable memory apparatuses to the fourth data processing mode, and may allocate and connect corresponding pluggable memory apparatus to the host that requested the setting of the fourth data processing mode.

Furthermore, even if the plurality of hosts HTS1 - HTSn do not request setting the fourth data processing mode, the memory appliance 500 itself may set at least one of the plurality of pluggable memory apparatuses to the fourth data processing mode by determining the type of operation of the hosts based on latency information included in the memory management information.

By allocating at least one of the plurality of pluggable memory apparatuses to the plurality of hosts HTS1 - HTSn as described above, the present disclosure may improve performance by enabling the computing system 400 to operate in an optimal operating environment.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A pluggable memory apparatus, comprising:
a plurality of memory sockets;
a slot configured to connect with an external device; and
a main controller communicably coupled to the plurality of memory sockets and the slot, and having an error correction function,
wherein the main controller is configured to set at least one data processing mode, from among a plurality of data processing modes, based on error rates of a plurality of memory modules mounted in the plurality of memory sockets and to remap input/output data according to the at least one data processing mode.

2. The pluggable memory apparatus of claim 1, wherein the plurality of memory modules include Dual in-line Memory Module (DIMM).

3. The pluggable memory apparatus of claim 1, wherein the main controller is configured to detect error rates by performing training on the plurality of memory modules.

4. A pluggable memory apparatus, comprising:
a plurality of memory modules mounted in a plurality of memory sockets;
a slot configured to connect with an external device; and
a main controller communicably coupled to the plurality of memory sockets and the slot, and having an error correction function,
wherein the main controller comprises:
at least one memory controller configured to perform training on the plurality of memory modules to detect error rates, configured to output memory management information including the error rates, and configured to generate error correction codes for input/output data;
a host interface communicably coupled to at least one host through the slot;
a data remapping circuit configured to remap the input/output data and the error correction codes according to at least one predetermined data processing mode; and
a board management controller configured to set the at least one data processing mode, from among a plurality of data processing modes, for the plurality of memory modules based on the memory management information, and configured to transmit and receive the memory management information to and from the host interface.

5. The pluggable memory apparatus of at least one claim of claim 1 and claim 4, wherein, in the plurality of data processing modes, memory capacity, bandwidth, and error correction capability of the error correction function are set differently.

6. The pluggable memory apparatus of claim 5, wherein the plurality of data processing modes includes:
a first data processing mode having a higher weighting of memory capacity and bandwidth relative to error correction capability of the error correction function;
a second data processing mode having a higher weighting of the error correction capability relative to the memory capacity and the bandwidth; and
a third data processing mode in which a weight of the error correction capability and a weight of the memory capacity and the bandwidth are set to intermediate values that are between corresponding values in the first data processing mode and the second data processing mode.

7. The pluggable memory apparatus of claim 6, wherein the plurality of data processing modes further includes:
a fourth data processing mode in which memory capacity for the error correction function is increased by compressing data according to each of the first data processing mode, the second data processing mode, and the third data processing mode.

8. The pluggable memory apparatus of claim 4, further comprising a data compression circuit configured to compress the input/output data to generate compressed data.

9. The pluggable memory apparatus of at least one claim of claim 1 and claim 4, wherein the main controller is configured to support Computer Express Link.

10. The pluggable memory apparatus of claim 6, wherein the main controller is configured to divide the plurality of memory modules into a plurality of groups according to the first data processing mode, and configured to allocate different channels to each of the plurality of groups.

11. The pluggable memory apparatus of claim 6, wherein the main controller is configured to:
divide the plurality of memory modules into a plurality of groups according to the second data processing mode;
allocate the same channel to two different groups of the plurality of groups; and
use one of the two different groups for data storage and the other for error correction.

12. The pluggable memory apparatus of claim 6, wherein the main controller is configured to:
divide the plurality of memory modules into a plurality of groups according to the third data processing mode;
allocate the same channel for a first group and a second group among the plurality of groups;
use at least one of memory modules of the first group for error correction of the second group and rest for data storage of the first group; and
use at least one of memory modules of the second group for error correction of the first group and rest for data storage of the second group.

13. The pluggable memory apparatus of claim 7, wherein the main controller is configured to compress data according to currently set data processing mode, from among the first data processing mode, the second data processing mode, and the third data processing mode, when the fourth data processing mode is selected in response to an external request.

14. The pluggable memory apparatus of claim 4, wherein the at least one memory controller comprises:
a plurality of memory interface blocks coupled with the plurality of memory modules divided into a plurality of groups on a per-group basis;
a plurality of error correction circuits configured to be coupled with the plurality of memory interface blocks, and configured to generate error correction codes for data transmitted through the plurality of memory interface blocks; and
a plurality of memory control blocks configured to be coupled with the plurality of error correction circuits, configured to perform training on the plurality of memory modules to detect the error rates, and configured to generate the memory management information including the error rates.

15. The pluggable memory apparatus of claim 6, wherein the at least one memory controller comprises:
a plurality of memory interface blocks coupled with the plurality of memory modules divided into a plurality of groups on a per-group basis;
a plurality of error correction circuits configured to generate error correction codes for data transmitted through each of the plurality of memory interface blocks, in one-to-one connection with the plurality of memory interface blocks, in the first data processing mode, and configured to generate error correction codes for data transmitted through one of the plurality of memory interface blocks, in connection with the one of the plurality of memory interface blocks, in the second data processing mode; and
a plurality of memory control blocks configured to be coupled with the plurality of error correction circuits, configured to perform training on the plurality of memory modules to detect the error rates, and configured to generate the memory management information including the error rates.

16. The pluggable memory apparatus of claim 4, wherein the host interface is configured to vary the number of signal lines to be used according to a currently set data processing mode according to the memory management information.
